# EUROPEAN PATENT APPLICATION

(11) **EP 2 472 566 A2**
(43) Date of publication of application: **04.07.2012**
(21) Application number: 11167417.2
(22) Date of filing: 25.05.2011
(51) Int. Cl.: H01L 21/02, H01L 21/20

(54) **Template, method for manufacturing the template and method for manufacturing vertical type nitride-based semiconductor light emitting device using the template**

(30) Priority: 04.01.2011 KR 20110000643
(71) Applicant: Semi-Materials Co., Ltd, Seongnam-si, Gyeonggi-do 463-400 (KR); Park, Kun, Bundang-gu Sengnam-si, Gyeonggi-do 463-440 (KR)
(72) Inventor: Oh, Chung-Seok, 339-764, Chungcheongnam-do (KR); Jang, Sung-Hwan, 445-724, Gyeonggi-do (KR); Jung, Ho-Il, 712-832, Gyeongsangbuk-do (KR); Park, Chi-Kwon, 704-742, Daegu (KR)
(74) Representative: Müller Schupfner & Partner

(57) **Abstract**

Disclosed herein is a method for manufacturing a template. The method includes growing a first nitride layer on a substrate; etching a top surface of the first nitride layer by supplying a chloride-based etching gas thereto; forming a plurality of first voids by growing a second nitride layer on the top surface of the first nitride layer; etching a top surface of the second nitride layer by supplying the etching gas thereto; and forming a plurality of second voids by growing a third nitride layer on the top surface of the second nitride layer. A method for manufacturing a nitride-based semiconductor light emitting device using the template is also disclosed. As a result, stress between lattices and dislocation defects are reduced by a plurality of voids formed in a nitride buffer layer, thereby improving quality of nitride layers grown in a template. In the case where a light emitting device is manufactured using the template, it is possible to improve workability of the manufacturing process and to enhance luminous efficacy of the light emitting device.

## Description

### BACKGROUND

### 1. Technical Field

The present invention relate to a technique for manufacturing a nitride-based semiconductor light emitting device using a template.

### 2. Description of the Related Art

Demand for nitride-based semiconductor light emitting devices continues to increase because of various advantages thereof, such as a long lifespan, low power consumption, excellent initial driving characteristics, high vibration resistance, and the like.

In general, a nitride-based semiconductor light emitting device includes a plurality of nitride layers including an n-type nitride layer, an active layer and a p-type nitride layer. Here, the n-type and p-type nitride layers provide electrons and holes to the active layer, so that light is emitted through recombination of the electrons and holes in the active layer.

However, since a substrate formed of a material such as sapphire (Al₂O₃) generally has a different lattice constant than a nitride layer, severe lattice distortion occurs when the nitride layer is directly grown on the substrate.

Accordingly, in recent years, a method for reducing lattice distortion in growth of a nitride layer using a template having an undoped nitride layer deposited on a substrate has been proposed. However, since a dislocation density of 10⁹ to 10¹⁰/cm² is obtained even in such a method, there is a limitation in improving crystal quality of the nitride layer.

Recently, as a method for reducing dislocation density, a growth technique, for example epitaxial lateral overgrowth (ELO), has been proposed. In this technique, a SiO₂ mask having a pattern is formed on a template having an undoped nitride layer deposited thereon and a nitride layer is then grown from an opening of the mask to induce lateral growth on the mask. However, since the growth technique includes SiO₂ film deposition based on chemical vapor deposition (CVD), resist coating, photolithography, etching and cleaning, and the like, the manufacturing process is complicated and takes much time.

### BRIEF SUMMARY

An aspect of the present invention is to provide a method for manufacturing a template and a method for manufacturing a nitride-based semiconductor light emitting device using the template, in which a nitride buffer layer having a porous structure is formed on a substrate, thereby reducing stress caused by a difference in lattice constant between the substrate and a nitride layer while preventing dislocation.

In accordance with one aspect of the invention, a method for manufacturing a template includes growing a first nitride layer on a substrate; etching a top surface of the first nitride layer by supplying a chloride-based etching gas thereto; forming a plurality of first voids by growing a second nitride layer on the top surface of the first nitride layer; etching a top surface of the second nitride layer by supplying the etching gas thereto; and forming a plurality of second voids by growing a third nitride layer on the top surface of the second nitride layer.

In accordance with another aspect of the invention, a method for fabricating a vertical type nitride-based semiconductor light emitting device includes: growing a nitride buffer layer having a plurality of voids on a growth substrate by repeating a process of growing nitride layers and an etching process a plurality of times; growing an n-type nitride layer, an active layer and a p-type nitride layer on top of the nitride buffer layer; forming a conductive substrate on top of the p-type nitride layer; removing the growth substrate using a portion where the plurality of voids is formed as a cutting surface; and forming an electrode pad by processing the cutting surface.

### BRIEF DESCRIPTION OF THE DRAWINGS

The above and other aspects, features and advantages of the invention will become apparent from the following description of the following embodiments given in conjunction with the accompanying drawings, in which:
Fig. 1 is a sectional view of a template according to an exemplary embodiment of the present invention;
Fig. 2 is a flowchart of a process of manufacturing the template of Fig. 1;
Fig. 3 is a schematic sectional view explaining the process of manufacturing the template of Fig. 2;
Fig. 4 is a scanning electron microscope (SEM) image showing a top surface of a first nitride layer obtained by performing a primary etching process in Fig. 3;
Fig. 5 is an SEM image showing a cross section of the template of Fig. 1;
Fig. 6 is a sectional view of a lateral type nitride-based semiconductor light emitting device manufactured using a template according to an exemplary embodiment of the present invention; and
Fig. 7 is a sectional view of a vertical nitride-based semiconductor light emitting device manufactured using a template according to an exemplary embodiment of the present invention.

### DETAILED DESCRIPTION

Exemplary embodiments of the invention will be described in detail with reference to the accompanying drawings. In the following embodiments, a template used in manufacturing a light emitting device will be mainly described. However, the present invention is not limited thereto, but may be applied to various templates used for growth of a nitride layer.

It will be understood that when an element such as a layer, film, region or substrate is referred to as being "on" another element, it can be directly on the other element or intervening elements may also be present. In contrast, when an element is referred to as being "directly on" another element, there are no intervening elements present.

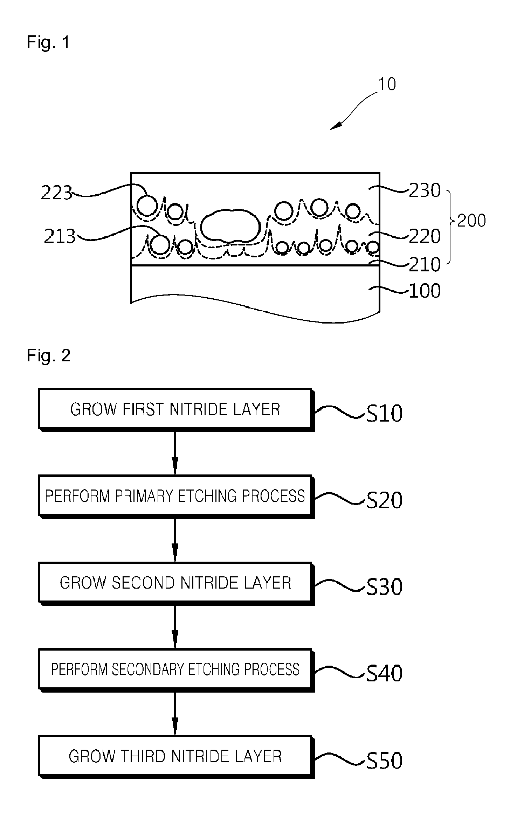

Fig. 1 is a sectional view of a template 10 according to an exemplary embodiment of the present invention.

As shown in Fig. 1, the template 10 according to this embodiment includes a substrate 100 and a nitride buffer layer 200 grown on the substrate 100. The nitride buffer layer 200 has a porous structure having a plurality of voids 213, 223 formed therein, and other nitride layers may be grown and stacked on the nitride buffer layer 200.

The substrate 100 defines a base surface on which a nitride layer starts to grow. The substrate 100 is made of a material suitable for lattice growth of the nitride layer. In this embodiment, a sapphire (Al₂O₃) substrate is used as the substrate 100. Here, the sapphire substrate has a hexagonal structure and is stable at high temperature. In addition, a substrate made of a material such as spinel (MgAlO₄), silicon carbide (SiC), silicon (Si), zinc oxide (ZnO), gallium arsenic (AsGa) or gallium nitride (GaN) may be used.

The nitride buffer layer 200 is formed on the sapphire substrate 100. In this embodiment, the nitride buffer layer 200 is configured using a GaN layer having the hexagonal system structure like the sapphire substrate 100. Alternatively, the nitride buffer layer 200 may be configured using a Group-III nitride layer.

The nitride buffer layer 200 is formed to have a structure in which a plurality of nitride layers made of a GaN material is stacked. The nitride buffer layer 200 is formed by etching a top surface of one of the nitride layers in a state where the nitride layer is grown on the sapphire substrate 100 and then growing another nitride layer on the nitride layer. Thus, the nitride buffer layer 200 is provided with a plurality of voids 213 and 223 formed at portions adjacent to interfaces between the nitride layers.

In this embodiment, the nitride buffer layer 200 includes a first nitride layer 210, a second nitride layer 220, and a third nitride layer 230. A plurality of first voids 213 is formed at portions adjacent to the interface between the first and second nitride layers 210 and 220, and a plurality of second voids is formed at portions adjacent to the interface between the second and third nitride layers 220 and 230.

Thus, as shown in Fig. 1, the second void 223 is formed on top of the first void 213, so that it is possible to form a structure in which the plural voids are arranged in a two-layered structure. Further, the second void 223 is combined with the previously formed first void 213 at a partial position, so that it is possible to form a large-scale void structure.

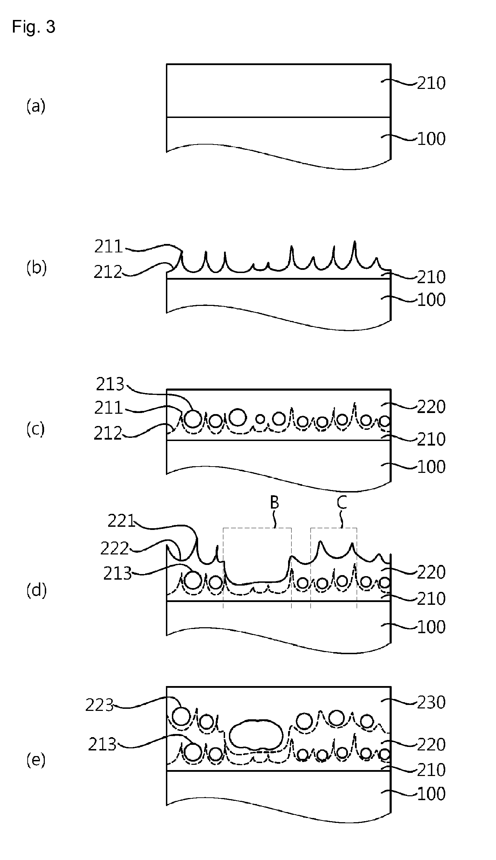

Fig. 2 is a flowchart of a process of manufacturing the template of Fig. 1, and Fig. 3 is a schematic sectional view explaining the process of manufacturing the template of Fig. 2. Hereinafter, the method for growing the nitride buffer layer 200 will be described in detail with reference to Figs. 2 and 3.

As shown in Fig. 3 (a), a first nitride layer 210 is grown to a thickness of 0.2 to 10 µm on a sapphire substrate 100 in S10. This operation may be performed using a metal organic chemical vapor deposition (MOCVD) apparatus, hydride vapor phase epitaxy (HVPE) apparatus or molecular beam epitaxy (MBE) apparatus. In this embodiment, the MOCVD apparatus is used to ensure satisfactory growth of a lattice of the nitride layer.

In this embodiment, the sapphire substrate 100 is placed inside MOCVD apparatus, and trimethyl gallium (TMGa) and ammonia (NH₃) are supplied together with hydrogen (H₂) as a carrier gas into the MOCVD apparatus, thereby growing the first nitride layer 210 made of an undoped-GaN (u-GaN) material. In an initial stage of the growth process, a buffer is formed by growing a 20 nm u-GaN layer at a low temperature of 500 to 700°C for about 10 to 30 minutes, and the u-GaN layer is additionally grown to have a thickness of about 2 µm by increasing the temperature up to 1000 to 1200°C. Accordingly, the first nitride layer is formed.

After the first nitride layer 210 is grown, the substrate 100 is transferred from the MOCVD apparatus to the HVPE apparatus, and the internal temperature of the HVPE apparatus increases to 800°C or higher. Then, a primary etching process is performed by supplying a chloride-based gas and ammonia (NH₃) into the HVPE apparatus in S20. In this embodiment, hydrogen chloride (HCl) is used as an example of the chloride-based gas. Here, the effect of etching the first nitride layer may be obtained even when supplying only the hydrogen chloride (HCI) or when supplying only the ammonia (NH₃) gas. However, the structure of the nitride layer at a portion where the etching is not performed may become unstable. Therefore, hydrogen chloride (HCl) gas may be supplied at a rate of 1,000 sccm or less and ammonia (NH₃) gas may be supplied at a rate of 100 to 2,000 sccm into the HVPE apparatus. In this embodiment, etching is performed by supplying the hydrogen chloride (HCl) gas at 300 sccm and the ammonia (NH₃) gas at 1,000 sccm.

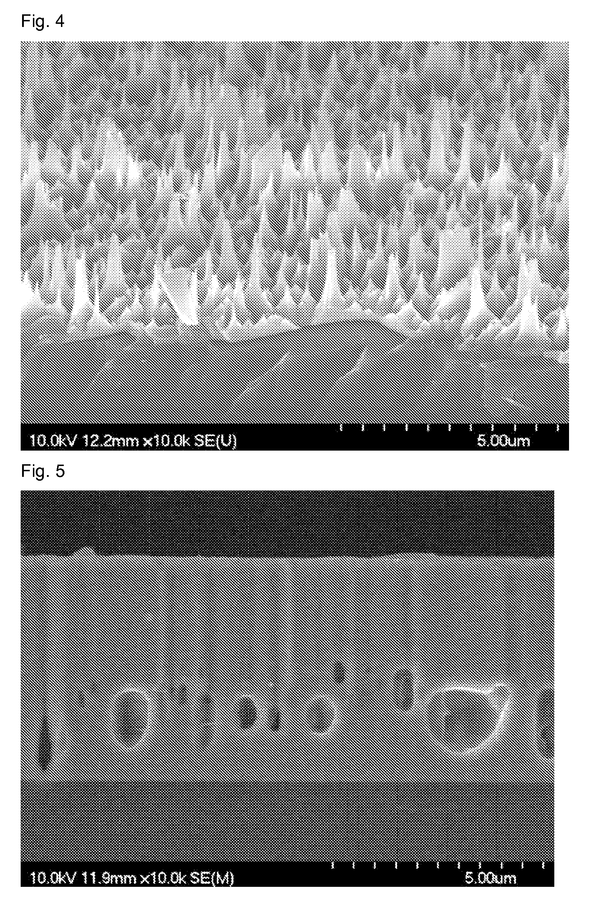

Fig. 4 is an SEM image showing the top surface of the first nitride layer after the primary etching process is performed for 15 minutes under the aforementioned process conditions. As shown in Fig. 4, as anisotropic etching is performed downwards on top of the first nitride layer 210 through the primary etching process, a plurality of first depressed valley structures 212 is formed at positions of the first nitride layer 210 at which etching is sufficiently performed, and a plurality of first nano structures 211 having a pillar shape is formed at positions of the first nitride layer 210 at which etching is not sufficiently performed.

The sizes and patterns of the nano structures and valley structures formed in the etching process may be controlled by adjusting the mixture ratio and supply amount of the hydrogen chloride (HCl) gas and the ammonia (NH₃) gas and time for which etching is performed. The etching process may be performed for 5 to 30 minutes.

After the plurality of first nano structures 211 and the plurality of first valley structures 212 are formed on the top of the first nitride layer 210 through the primary etching process, a second nitride layer 220 is grown on top of the first nitride layer 210 (S30). The growth of the second nitride layer 220 may be performed using an MOCVD apparatus, HVPE apparatus, MBE apparatus or the like. In this embodiment, the second nitride layer 220 is grown using the HVPE apparatus. In this case, the manufacturing process can be simplified by performing the process of growing the second nitride layer 220 together with the primary etching process and the following secondary etching process in the HVPE apparatus in an in-situ manner.

After the primary etching process is completed, the temperature of the interior of the MOCVD apparatus is increased to 1,000 to 1,300°C, and gallium chloride (GaCl) gas and ammonia (NH₃) gas are then supplied to a process space of the MOCVD apparatus. The gallium chloride (GaCl) gas may be generated through a reaction between hydrogen chloride (HCl) gas and gallium by passing the hydrogen chloride (HCl) gas over a gallium boat containing gallium source.

In this process, the second nitride layer 220 made of a GaN material is formed through reaction between the gallium chloride (GaCl) gas and the ammonia (NH₃) gas at the top of the first nitride layer 210. As shown in Fig. 3 (c), the second nitride layer 220 is grown while forming a roof structure at a top of the first nano structures 211, and forms a plurality of first voids 213 together with the first valley structure 212 and the first nano structures 211.

Meanwhile, after the growth of the second nitride layer 220 is completed, a secondary etching process is performed on the second nitride layer 220 (S40). As described above, the secondary etching process is performed in the HVPE apparatus in an in-situ manner. In the secondary etching process, a chloride-based gas (hydrogen chloride gas is used in this embodiment) and ammonia (NH₃) gas are supplied into the HVPE apparatus in a state in which the internal temperature of the HVPE apparatus is maintained as 800°C or higher, as in the primary etching process. As anisotropic etching is performed, a plurality of second valley structures 222 with a downwardly recessed shape is formed at positions of a top surface of the second nitride layer 220, at which the etching is further performed, and a plurality of second nano structures 221 with a pillar shape is formed at positions of the top surface of the second nitride layer 220, at which the etching is not further performed.

As shown in Fig. 3 (d), anisotropic etching is performed to a depth shallower than the thickness of the second nitride layer that forms the roof above the first void at a position where the secondary etching process is performed relatively weak (see region C), and therefore, the second valley structures 222 and the second nano structures 221 may be formed on top of the first void 213.

As the second nitride layer 220 that forms the roof on top of the first void 213 is etched, the previously formed first void 213 is upwardly opened at a position where the secondary etching process is performed relatively largely (see region B). Thus, at such a position, the second valley structure 222 formed in the secondary etching process can be formed to have a relatively large width and depth while including the region of the previously formed first void 213.

As described above, the secondary etching process is performed in a state where the first voids 213 are formed, and hence different structures may be formed depending on how much etching is performed. Thus, structures with various shapes can be formed by controlling the growth thickness of the second nitride layer 220, the time during which the secondary etching process is performed, the flow rate of the etching gas in the secondary etching process, or the like.

After the secondary etching process is completed, operation of cooling the substrate 100 for a predetermined time is performed. The cooling operation is performed by natural cooling in the HVPE apparatus, and the nitride layers grown on the substrate can be stabilized through this process. The cooling operation may be performed for 15 to 60 minutes. In this embodiment, natural cooling is performed for 30 minutes.

Subsequently, the substrate 100 is transferred from the HVPE apparatus to the MOCVD apparatus so as to grow a third nitride layer 230. The third nitride layer 230 may be grown in an apparatus other than the MOCVD apparatus. However, in this embodiment, the third nitride layer 230 forms an upper structure of the nitride buffer layer 200, and hence the MOCVD apparatus is used to induce satisfactory lattice growth.

The substrate 100 is first placed inside the MOCVD apparatus, and the temperature of a process space is increased by driving a heater so as to form the growth environment of the third nitride layer 230. Ammonia (NH₃) gas may be continuously supplied to the MOCVD apparatus while increasing the temperature of the process space. As described above, since the ammonia (NH₃) gas is supplied to the MOCVD apparatus, it is possible to prevent cracks from occurring in the first and second nitride layers 210, 220 previously grown during the increase of the temperature and to remove an oxide film that may be formed on the second nitride layer 220 in the operation of transferring the substrate 100.

If the temperature of the MOCVD apparatus is sufficiently increased, the third nitride layer 230 made of a GaN material is grown by supplying trimethyl gallium (TMGa) and ammonia (NH₃) together with hydrogen (H₂) as a carrier gas into the MOCVD apparatus.

In an initial stage of this process, a relatively low-pressure and high-temperature environment may be formed as compared with a general GaN growth environment, thereby allowing horizontal growth to be performed at an upper portion of the nano structure 221 of the second nitride layer 220. Thus, in this embodiment, a roof structure is formed by growing the third nitride layer 230 in a horizontal direction from the top of the second nano structures 221 under an environment of a high temperature of 1,150 to 1,250°C and a low pressure of 200 mb or lower. The GaN layer is vertically grown to 1 to 5 µm or so by controlling the process environment to be a temperature of 1,000 to 1,200°C and a pressure of 300 mb or higher. Accordingly, the upper structure of the nitride buffer layer 200 is formed.

As shown in Fig. 3 (e), the third nitride layer 230 forms a plurality of second voids 223 together with the second nano structures 221 and the second valley structures 222 through this process. The second voids 223 may be formed in various shapes according to the second valley structures 222 formed through the secondary etching process.

The second void 223 is formed above the first void 213 at a position where the second valley structure is formed on a top portion of the first void 213 (see region C). That is, the first void 213 is formed adjacent to an interface between the first and second nitride layers 210 and 220, and the second void 223 is formed adjacent to an interface between the second and third nitride layers 220 and 230, thereby forming a structure in which the voids are arranged in two layers.

On the other hand, the second void 223 is formed to combine the region of the previously formed first void 213 at a position where the second valley structure extends up to the space in which the first void 213 is previously formed (see region B). Thus, as shown in Fig. 3 (e), the second void 223 formed as described above is formed in a large scale as compared with the other voids 213 which are not combined with the first voids 213.

Fig. 5 is an SEM image showing a cross section of the nitride buffer layer manufactured by the method of Fig. 2. As shown in Fig. 5, the nitride buffer layer 200 can have various structures of the voids 213 and 223 formed therein by performing the process of growing the nitride layers and the process of etching the nitride layers a plurality of times.

The structure of voids can reduce stress caused by differences in lattice constant and thermal expansion coefficient between the nitride layer and the sapphire substrate. Further, since dislocations generated in the nitride layer adjacent to the substrate 100 are eliminated by the structure of the voids, it is possible to prevent the dislocations from propagating toward the upper portion of the nitride layer. Particularly, in a structure where a plurality of voids is disposed in a stacked arrangement, the upper voids prevent propagation of some dislocations passing through the lower voids, thereby doubly blocking propagation of the dislocations.

Practically, as a result obtained by measuring the nitride buffer layer grown according to this embodiment, dislocations of 10⁶/cm² or so were measured even when the thickness of the nitride buffer layer was 2 to 4 µm, showing that the dislocation density of the nitride buffer layer is decreased by 1 % or lower as compared with a conventional nitride buffer layer.

Thus, the template according to the embodiments of the invention has a nitride buffer layer in which stress is reduced and a dislocation density is decreased, so that it is possible to grow nitride layers of a light emitting device, which has a satisfactory crystal quality on a top surface of the nitride buffer layer, and to manufacture a light emitting device of which light emitting efficiency is improved by 30 to 40% as compared with a conventional light emitting device as an experimental result.

Meanwhile, the configuration including a structure of voids disposed in a stacked arrangement in one nitride buffer layer and a structure of a large-sized void has been described in the aforementioned embodiment. However, this is only an example given for convenience of illustration, and the present invention is not limited thereto. That is, various structures of voids may be formed by controlling the growth thickness of the second nitride layer, the time during which the secondary etching process is performed, the flow rate of an etching gas, or the like. In this embodiment, the etching process is performed twice. However, the etching process and the process of growing the nitride layer may be repeatedly performed three times or more.

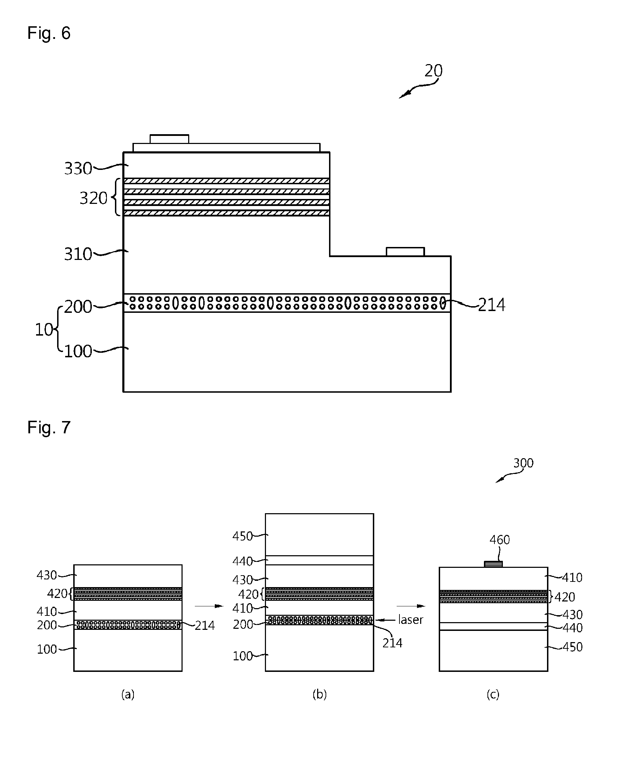

In the template according to the embodiments of the invention, nitride layers of the light emitting device can be grown on the top surface of the nitride buffer layer as described above. Fig. 6 is a sectional view of a lateral type nitride-based semiconductor using a template according to an exemplary embodiment of the present invention.

As shown in Fig. 6, the vertical nitride-based semiconductor light emitting device 20 has a structure in which an n-type nitride layer 310, an active layer 320 and a p-type nitride layer 330 are sequentially stacked on a template 10. Thus, a third nitride layer 230 of a nitride buffer layer 200 is grown in an MOCVD apparatus, and nitride layers of the light emitting device can be grown through consecutive processes.

In the case where first, second and third nitride layers 210, 220 and 230 are grown using an undoped GaN material as described in this embodiment, the third nitride layer 230 is grown, and the n-type nitride layer 310, the active layer 320 and the p-type nitride layer 330 are sequentially grown by controlling temperature and process gas.

Alternately, after a secondary etching process is performed, an n-type nitride layer may be grown as the third nitride layer 230, and an active layer and a p-type nitride layer may then be additionally grown on the n-type nitride layer.

As described above, in the lateral type nitride-based semiconductor light emitting device 20 according to the embodiment, a plurality of voids is formed in a nitride layer adjacent to a substrate 100, and hence stress and dislocation density of the nitride layer are decreased. Thus, it is possible to improve internal quantum efficiency and to prevent polarization.

The voids have a different refractive index from an adjacent nitride layer. Thus, light propagating toward the substrate is scattered or refracted by passing through the plurality of voids, so that the path of the light is changed. Accordingly, it is possible to improve the light extraction efficiency of the light emitting device.

Meanwhile, the template according to the embodiment of the invention may also be applied to a vertical nitride-based semiconductor light emitting device. Fig. 7 schematically illustrates a method for manufacturing a vertical nitride-based light emitting device using a template according to an exemplary embodiment of the invention.

Like the template manufacturing method as described above, a nitride buffer layer 200 having a porous structure is grown on a growth substrate by repeating a process of growing nitride layers and a process of etching the nitride layers. Then, an n-type nitride layer 410, an active layer 420 and a p-type nitride layer 430 are directly grown on top of nano structures formed by the etching process. The nitride buffer layer is a tertiary nitride layer, and the n-type nitride layer may be grown on the nitride buffer layer. A plurality of voids is disposed at a boundary between the undoped nitride layer and the n-type nitride layer (see Fig. 7 (a)).

After the growth of the multi-layered nitride layer is completed, a conductive adhesive layer 440 is formed on top of the p-type nitride layer 430, and a conductive substrate 450 is attached to the conductive adhesive layer 440. Here, the conductive substrate 450 is electrically connected to an external circuit so as to form a p-side electrode.

Then, operation of removing the growth substrate 100 from the nitride layers (see Fig. 7 (b)) is performed. Since the nitride buffer layer exists in the form of nano structures, a region having a plurality of voids 213, 223 formed therein has a relatively weak structure as compared with the other nitride layers. Thus, the growth substrate 100 can be easily separated from the nitride layers using the formation position of the plurality of voids 213 and 223 as a sacrificial surface. Particularly, in the case where large-sized voids are formed by performing the etching process a plurality of times as described in the method of fabricating the template, the structure of the sacrificial surface is weaker, and hence separation of the growth substrate can be more easily performed.

A laser lift off (LLO) process may be used to remove the substrate by irradiating a nitride layer adjacent to the growth substrate 100 with a laser. Conventionally, since a nitride layer constitutes a strong lattice structure, the nitride layer is seriously damaged upon laser irradiation, thereby lowering yield. However, according to the invention, the position having a relatively weak structure due to the plurality of voids 213, 223 is irradiated with a laser, so that it is possible to minimize damage of the nitride layer.

In addition to the LLO process described above, the growth substrate 100 may be separated from the nitride layer by controlling the temperatures of the nitride layer and the growth substrate 100. Since there is a large difference in thermal expansion coefficient between the nitride layer and the growth substrate made of sapphire, cooling is performed from a high-temperature at which the nitride layer is grown on the growth substrate, so that large stress is generated in the nitride layer due to thermal deformation. In an experimental result, as the growth substrate is cooled, cracks occur along portions at which the plurality of voids are formed, and the growth substrate can be separated from the nitride layer by additionally providing a small amount of energy to the portions.

As described above, in the light emitting device according to the embodiments of invention, the growth substrate can be easily separated from the nitride layer based on the position at which the plural voids are formed. Further, since a change in stress applied to the nitride layer in the separation of the growth substrate is relatively small, it is possible to form a freestanding layer with satisfactory quality as compared with a conventional light emitting device.

Meanwhile, after the growth substrate 100 is separated, operation of processing a sacrificial surface to expose the n-type nitride layer 410 is performed to form an electrode pad 460. Conventionally, it is difficult to perform this operation while deciding whether or not the n-type nitride layer 410 is exposed in processing the sacrificial surface. However, according to the present invention, since the sacrificial surface is formed at a boundary between the undoped nitride layer and the n-type nitride layer 410, this operation can be more easily performed.

As described above, it is possible to form a nitride layer with satisfactory quality and to provide a light emitting device having improved workability in manufacture of the light emitting device and excellent light emitting efficiency and durability.

As such, according to the embodiments, stress between lattices and dislocation defects can be reduced by a plurality of voids formed in an undoped nitride layer, thereby improving the quality of a nitride layer additionally grown on a template.

Further, when a light emitting device is manufactured using the template, it is possible to improve workability of the manufacturing process and to enhance luminous efficacy of the light emitting device.

Although some embodiments have been described herein, it should be understood by those skilled in the art that these embodiments are given by way of illustration only, and that various modifications, variations, and alterations can be made without departing from the spirit and scope of the invention. Therefore, the scope of the invention should be limited only by the accompanying claims and equivalents thereof.

## Claims

1. A template including a nitride buffer layer, **characterized by** comprising:
a substrate; and
a nitride buffer layer formed on the substrate to have a plurality of voids stacked and arranged in a plurality of lines.

2. A method for manufacturing a template including a nitride buffer layer, **characterized by** comprising:
growing a first nitride layer on a substrate;
etching a top surface of the first nitride layer by supplying a chloride-based etching gas thereto;
forming a plurality of first voids by growing a second nitride layer on the top surface of the first nitride layer;
etching a top surface of the second nitride layer by supplying the etching gas thereto; and
forming a plurality of second voids by growing a third nitride layer on the top surface of the second nitride layer.

3. The method of claim 2, **characterized in that** the first nitride layer and the third nitride layer are grown in a metal organic chemical vapor deposition (MOCVD) apparatus.

4. The method of claim 3, **characterized in that** the second nitride layer is grown in a hydride vapor phase epitaxy (HVPE) apparatus.

5. The method of claim 2, **characterized in that** the plurality of second voids is disposed in a stacked arrangement on top of the plurality of first voids.

6. The method of claim 5, **characterized in that** the etching the second nitride layer is performed to a depth shallower than the thickness of the second nitride layer.

7. The method of claim 5, **characterized in that** the plurality of first voids is formed adjacent to an interface between the first and second nitride layers, and the plurality of second voids is formed adjacent to an interface between the second and third nitride layers.

8. The method of claim 2, **characterized in that** the second nitride layer is etched from the top surface of the second nitride layer to communicate with the first void.

9. The method of claim 8, **characterized in that** the second void is larger than the first void.

10. A method for manufacturing a vertical nitride-based semiconductor light emitting device using a template including a nitride buffer layer, **characterized by** comprising:
growing a nitride buffer layer having a plurality of voids on a growth substrate by repeating a process of growing nitride layers and an etching process twice or more;
growing an n-type nitride layer, an active layer and a p-type nitride layer on top of the nitride buffer layer;
forming a conductive substrate on top of the p-type nitride layer;
removing the growth substrate using a portion where the plurality of voids is formed as a cutting surface; and
forming an electrode pad by processing the cutting surface.

11. The method of claim 10, **characterized in that** the growing the nitride buffer layer comprises:
growing a first nitride layer on the growth substrate;
etching a top surface of the first nitride layer by supplying an etching gas thereto;
forming a plurality of first voids by growing a second nitride layer on the top surface of the first nitride layer;
etching a top surface of the second nitride layer by supplying the etching gas thereto; and
forming a plurality of second voids by growing a third nitride layer on the top surface of the second nitride layer.

12. The method of claim 11, **characterized in that** the first and third nitride layers are grown in an MOCVD apparatus, and the second nitride layer is grown in an HVPE apparatus.

13. The method of claim 10, **characterized in that** the plurality of voids is disposed in a stacked arrangement by forming at least two lines in the nitride buffer layer.

14. The method of claim 10, **characterized in that** the removing the growth substrate comprises irradiating the portion having the plurality of voids formed therein with a laser.

15. The method of claim 10, **characterized in that** the removing the growth substrate comprises cooling the nitride buffer layer to induce cracks at the portion having the plurality of voids formed therein.
